Europäisches Patentamt

European Patent Office   (11) Numéro de publication:   **0 142 410**

Office européen des brevets   **A1**

(12)   # DEMANDE DE BREVET EUROPEEN

(21) Numéro de dépôt: 84402042.0

(22) Date de dépôt: 11.10.84

(51) Int. Cl.⁴: **G 05 D 23/24**
**H 03 L 1/04**

(30) Priorité: 18.10.83 FR 8316549

(43) Date de publication de la demande:
22.05.85 Bulletin 85/21

(84) Etats contractants désignés:
CH DE GB IT LI NL SE

(71) Demandeur: COMPAGNIE D'ELECTRONIQUE ET DE
PIEZO-ELECTRICITE - C.E.P.E.
44, rue de la Glacière
F-95100 Argenteuil(FR)

(72) Inventeur: Chauvin, Jaques
THOMSON-CSF SCPI 173, bld Haussmann
F-75379 Paris Cedex 08(FR)

(72) Inventeur: Canzian, Patrice
THOMSON-CSF SCPI 173, bld Haussmann
F-75379 Paris Cedex 08(FR)

(74) Mandataire: Ruellan-Lemonnier, Brigitte et al,
THOMSON-CSF SCPI 173, boulevard Haussmann
F-75379 Paris Cedex 08(FR)

(54) Procédé et dispositif permettant le réglage du chauffage d'une enceinte thermostatée d'un oascillateur notamment à quartz.

(57) La présente invention a pour object un procédé et un dispositif permettant le réglage du chauffage d'une enceinte thermostatée d'un oscillateur à quartz.

Dans une première étape, on soumet l'enceinte thermostatée (1) à une température extérieure voisine de la température maximale de fonctionnement et on mesure la fréquence $f_0$ de l'oscillateur (Q, E). Dans une seconde étape, on soumet l'enceinte thermostatée (1) à une température extérieure voisine de la température minimale de la gamme et on annule l'écart $\Delta f_0$ de la fréquence de l'oscillateur (Q, E) par rapport à la fréquence $f_0$ en modifiant la répartition des puissances dissipées par les éléments de chauffage ($T_1$, $T_2$, $T_3$, $T_4$) de l'enceinte thermostatée (1). Le chauffage de l'enceinte (1) est réalisé par une chaîne de circuits semiconducteurs stabilisateurs de tension reliés en série, chacun des circuits étant traversé par un courant de chauffage I régulé. Le réglage du chauffage a lieu par modification des tensions stabilisées des circuits.

FIG_5

# 0142410

## PROCEDE ET DISPOSITIF PERMETTANT LE REGLAGE
## DU CHAUFFAGE D'UNE ENCEINTE THERMOSTATEE
## D'UN OSCILLATEUR NOTAMMENT A QUARTZ

La présente invention a pour objet un procédé et un dispositif permettant le réglage du chauffage d'une enceinte thermostatée d'un oscillateur notamment à quartz.

On connait du brevet européen N° 4 233 dont est titulaire la demanderesse un dispositif de régulation thermique d'une enceinte comprenant d'une part un circuit de mesure de température et d'autre part un circuit de chauffage de l'enceinte alimenté par une source de tension et contrôlé par le circuit de mesure de température, celui-ci étant constitué d'un pont de résistances dont une branche comprend une pluralité d'éléments à résistance variable en fonction de la température, et d'un circuit amplificateur délivrant, en fonction de la différence de potentiel existant entre l'extrémité d'une des diagonales du pont, un signal de contrôle. Le circuit de chauffage est constitué par une pluralité de circuits semiconducteurs stabilisateurs de tension, chacun de ces circuits semiconducteurs reliés en série étant soumis à une fraction sensiblement égale de la tension d'alimentation et étant traversé par un courant de chauffage réglable par l'intermédiaire d'un transistor de commande soumis audit signal de contrôle. Le chauffage peut être effectué par des transistors ou par des régulateurs de tension.

Ce dispositif permet de réaliser un chauffage relativement homogène, à une température déterminée d'une enceinte de dimension quelconque sans nécessité d'appairer les circuits semiconducteurs utilisés. Chaque transistor de la chaîne série est soumis à une fraction de la tension totale et à la totalité du courant de chauffage et tous les transistors dissipent une puissance identique.

Un tel montage permet d'obtenir un chauffage homogène d'une enceinte dans la mesure et dans la mesure seulement où celle-ci se présente sous une forme homogène du point de vue thermique. Or, la Demanderesse a constaté comme on va le montrer ci-dessous que les enceintes réalisables en pratique, en particulier pour les oscillateurs piézo-électriques, présentent certaines disparités de ce point de vue.

Dans le cas où on répartit uniformément les puissances de chauffage autour de l'enceinte, les disparités de conductibilité thermique des composants localisés en diverses régions de celle-ci vont entrainer des inhomogénéïtés de température, se traduisant pour l'utilisateur par une dérive thermique inexplicable de l'oscillateur, alors que le signal d'erreur de l'asservissement de température est quasi nul.

Lorsque la température extérieure est très différente de la température de référence à laquelle est maintenue l'enceinte thermostatée et qui correspond approximativement à la température maximale de la gamme de température prévue pour le fonctionnement de l'oscillateur, la dérive est maximale et la Demanderesse a été amenée a interpréter ce résultat comme étant dû au fait que la température de l'électronique de l'oscillateur à quartz est sensiblement différente de la température de référence à laquelle on souhaite la maintenir, différence qui se traduit en effet par une dérive de la fréquence du quartz par rapport à la fréquence $f_0$ souhaitée, qui évolue comme celle qui a été constatée.

L'invention a par conséquent pour objet un procédé et un dispositif permettant le réglage du chauffage d'une enceinte thermostatée d'un oscillateur notamment à quartz et qui permettent de compenser au moins partiellement les défauts d'homogénéïté de température à l'intérieur de l'enceinte, lesquelles sont dues à la dissymétrie de celle-ci du point de vue thermique.

En effet, s'il est relativement facile d'obtenir un bon couplage thermique entre le boîtier contenant l'élément piézo-électrique, notamment un quartz, et l'enceinte, il n'en va pas de même pour l'électronique associée, laquelle ne peut être qu'imparfaitement couplée thermiquement à l'enceinte étant donné qu'elle ne présente pas un contour extérieur régulier.

3

Selon le procédé suivant l'invention, le chauffage de l'enceinte étant assuré par une pluralité d'éléments de chauffage asservis à faire correspondre la température mesurée de l'enceinte à une température de référence. Il comporte les étapes suivantes :

a - soumettre l'enceinte thermostatée à une température extérieure voisine de la température maximale de la gamme de température prévue pour l'enceinte et mesurer la fréquence $f_0$ de l'oscillateur,

b - soumettre l'enceinte thermostatée à une température extérieure voisine de la température minimale de la gamme de température prévue pour l'enceinte et annuler l'écart de fréquence de l'oscillateur par rapport à la fréquence $f_0$ mesurée précédemment, en modifiant la répartition des puissances dissipées par les différents éléments de chauffage d'où il résulte que l'on compense au moins partiellement les défauts d'homogénéité de température à l'intérieur de l'enceinte sur toute la gamme de température de fonctionnement de l'oscillateur.

On pourra avantageusement lors de l'étape a procéder à l'ajustage de la température de référence.

Selon une réalisation préférée, le circuit de chauffage comporte une chaîne de circuits semiconducteurs stabilisateurs de tension reliés en série et soumis à une fraction réglable d'une tension d'alimentation de manière à permettre ladite modification de la répartition des puissances dissipées, les circuits semiconducteurs étant traversés par un courant de chauffage commandé par l'intermédiaire d'un circuit de commande qui est situé à une extrémité de la chaîne et est soumis à un signal de contrôle représentatif de l'écart entre la température mesurée de l'enceinte et la température de référence.

Le circuit de commande peut être un desdits circuits semiconducteurs et participer de ce fait au chauffage de l'enceinte.

Le circuit de chauffage peut par exemple comporter quatre éléments de chauffage à savoir successivement un premier constituant éventuellement ledit circuit de commande, un deuxième, un

4

troisième et un quatrième, ladite modification de la répartition des puissances dissipées s'effectuant en décalant de manière symétrique et en sens contraire lesdites fractions de la tension d'alimentation des deuxième et quatrième circuits semiconducteurs stabilisateurs de tension.

L'invention concerne également un dispositif adapté à la mise en oeuvre du procédé. Il comporte d'une part un circuit de contrôle de température d'une enceinte d'un oscillateur notamment à quartz comprenant un capteur de température et d'autre part un circuit de chauffage de l'enceinte alimenté par une source de tension et régulé par le circuit de contrôle de température, celui-ci délivrant un signal de contrôle représentatif de l'écart entre la température mesurée de l'enceinte et la température de référence, le circuit de chauffage étant constitué par une chaîne de circuits semiconducteurs stabilisateurs de tension reliés en série, au moins un desdits circuits stabilisateurs de tension présentant un moyen pour modifier sa tension stabilisée, chacun des circuits semiconducteurs étant traversé par un courant de chauffage régulé par l'intermédiaire d'un circuit de commande et qui est situé à une extrémité de ladite chaîne et soumis audit signal de contrôle. Les circuits stabilisateurs de tension assurant le chauffage de l'enceinte sont répartis dans une pluralité de régions de l'enceinte et la modification d'au moins une dite tension stabilisée est réalisée de manière à compenser au moins partiellement les défauts d'homogénéité de température à l'intérieur de l'enceinte.

Selon un mode de réalisation avantageux, le capteur de température est disposé au voisinage du boîtier de l'élément piézo-électrique, notamment un quartz, de l'oscillateur et en contact thermique avec celui-ci.

Les circuits stabilisateurs de tension assurant le chauffage de l'enceinte peuvent être répartis sur le pourtour de celle-ci, de préférence en contact thermique avec un boîtier thermiquement conducteur constituant l'enceinte thermostatée, et dans lequel sont disposés le boîtier de l'élément piézo-électrique de l'oscillateur et

5

son électronique associée. L'enceinte thermostatée peut comporter une première région où est disposé l'élément piézo-électrique et une deuxième région où est disposée son électronique associée, et les circuits stabilisateurs de tension sont alors disposés selon un premier groupe en vis-à-vis de la première région et selon un deuxième groupe en vis-à-vis de la deuxième région.

Selon un mode de réalisation, les circuits stabilisateurs de tension sont constitués par une chaîne de transistors recevant chacun sur sa base une tension donnée, l'émetteur et le collecteur des transistors adjacents étant reliés entre eux, la modification d'au moins une tension stabilisée consistant en le réglage de la tension de base d'au moins un des transistors de la chaîne.

Dans le cas où l'enceinte thermostatée comporte une première région où est disposé le quartz et une deuxième région où est disposée son électronique associée, on réalisera avantageusement les circuits stabilisateurs de tension sous la forme d'une chaîne de quatre transistors, à savoir successivement un premier, un deuxième, un troisième et un quatrième transistor, recevant chacun sur sa base une tension donnée, l'émetteur et le collecteur des transistors adjacents étant reliés entre eux, le premier transistor pouvant constituer le circuit de commande, les circuits stabilisateurs d'un desdits groupes sont constitués par les deux transistors extrêmes de la chaîne et ceux de l'autre groupe par les deux transistors centraux de la chaîne, les tensions de base du deuxième et du quatrième transistor de la chaîne étant réglables. Le premier groupe de transistors est avantageusement constitué par les deux transistors centraux de la chaîne à savoir le deuxième et le troisième, et le second groupe par les transistors extrêmes de la chaîne, à savoir le premier et le quatrième.

Selon un mode de réalisation avantageux des circuits stabilisateurs de tension, au moins un desdits circuits présentant un moyen pour modifier sa tension stabilisée est constitué par un transistor monté en Darlington et dont la tension de base est réglable. La tension de base d'entrée du ou des Darlington est alors déterminée

6

par un pont diviseur alimenté à tension constante. Les autres transistors et notamment le transistor constituant le circuit de commande pourront également être montés en Darlington.

L'invention sera mieux comprise à la lecture de la description qui va suivre, donnée à titré d'exemple non limitatif, en liaison avec les figures ci-annexées, où :

- la figure 1 représente un mode de réalisation d'un dispositif de régulation thermique d'une enceinte selon l'art antérieur constitué par le brevet européen n° 4 233 ;

- la figure 2 illustre la répartition des tensions dans un tel dispositif ;

- la figure 3 représente un mode de réalisation de l'invention dans lesquels les circuits stabilisateurs sont constitués par une chaîne de transistors ;

- la figure 4 représente une variante de la figure 3 dans laquelle les transistors sont montés en Darlington ;

- la figure 5 représente un schéma d'une enceinte thermostatée selon l'invention, dont un mode de réalisation est représenté aux figures 6a à 6d.

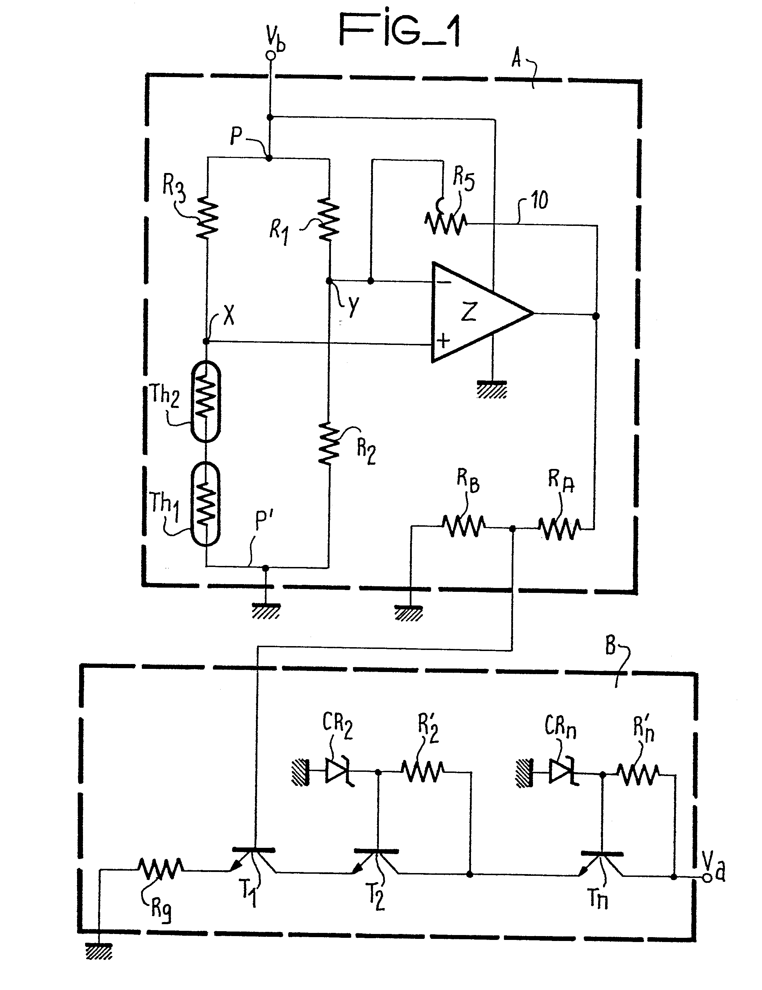

Selon la figure 1, le circuit de mesure de températeure A comporte une pluralité d'éléments thermosensibles, ici deux thermistances $Th_1$ et $Th_2$ connectées en série. Les thermistances sont incluses dans une des branches d'un pont de résistance dont les autres éléments sont R2, R1 et R3. Une des diagonales du pont est alimentée en tension continue et reçoit à cet effet une tension $V_b$ au point P, le point P' opposé de la diagonale étant à la masse.

Les extrémités XY de l'autre des diagonales du pont sont reliées aux deux entrées d'un amplificateur opérationnel Z contre-réactionné par une résistance variable $R_5$.

Le circuit de chauffage B comporte une chaîne de transistors connectés en série par leur émetteur et leur collecteur, et repérés de $T_1$ à $T_n$. Ces transistors sont montés en régulateur de tension. La base des transitors $T_2$ à$T_n$ est maintenu à un potentiel constant par un pont résistance-diode Zener telle que $R'_n$, et $CR_n$ pour le transistor $T_n$.

Pour sa part, la base du transistor $T_1$ est reliée à la sortie de l'amplificateur opérationnel Z à travers un pont diviseur $R_A$, $R_B$. Le montage du transistor $T_1$ en émetteur suiveur fait que sa tension de base se retrouve au niveau de son émetteur, et comme celui-ci est connecté à la masse par l'intermédiaire d'une résistance $R_9$, le courant I dans la chaîne des transistors est déterminée par les variations de la tension de base du transistor $T_1$, lequel peut participer au même titre que les autres transistors au chauffage de l'enceinte. Les tensions sont choisies de telle manière que les transistors dissipent une puissance égale.

Un tel chauffage assure une homogénéïté de température à l'intérieur d'une enceinte idéale, c'est-à-dire homogène du point de vue thermique.

Cette condition est difficile à satisfaire en pratique et de ce fait les performances de stabilité en fréquence de l'oscillateur à quartz sont sensiblement détériorées par les inhomogénéïtés thermiques de l'enceinte, lesquelles sont d'autant plus importantes que l'écart entre la température extérieure et la température à laquelle l'enceinte est thermostatée est important.

Ces inhomogénéïtés résiduelles sont de relativement faible amplitude et sont de ce fait difficiles à éliminer.

Cependant, il est souhaitable de remédier à ces inhomogénéïtés de manière à rendre possible la mise en oeuvre d'enceinte thermostatées fonctionnant dans une marge de gamme de température et adaptée à des quartz de très haute stabilité.

Sur la figure 2, on constate que, selon l'art antérieur, chaque transistor présente entre son émetteur et son collecteur une différence de tension $\Delta V$ et est traversé par le courant I, c'est-à-dire que chaque transistor participant au chauffage dissipe la même puissance. On remarquera que, si on souhaite que $T_1$ ne participe pas au chauffage, il suffit que $CR_2$ ait une tension de Zener très faible et $T_1$ dissipera peu.

8

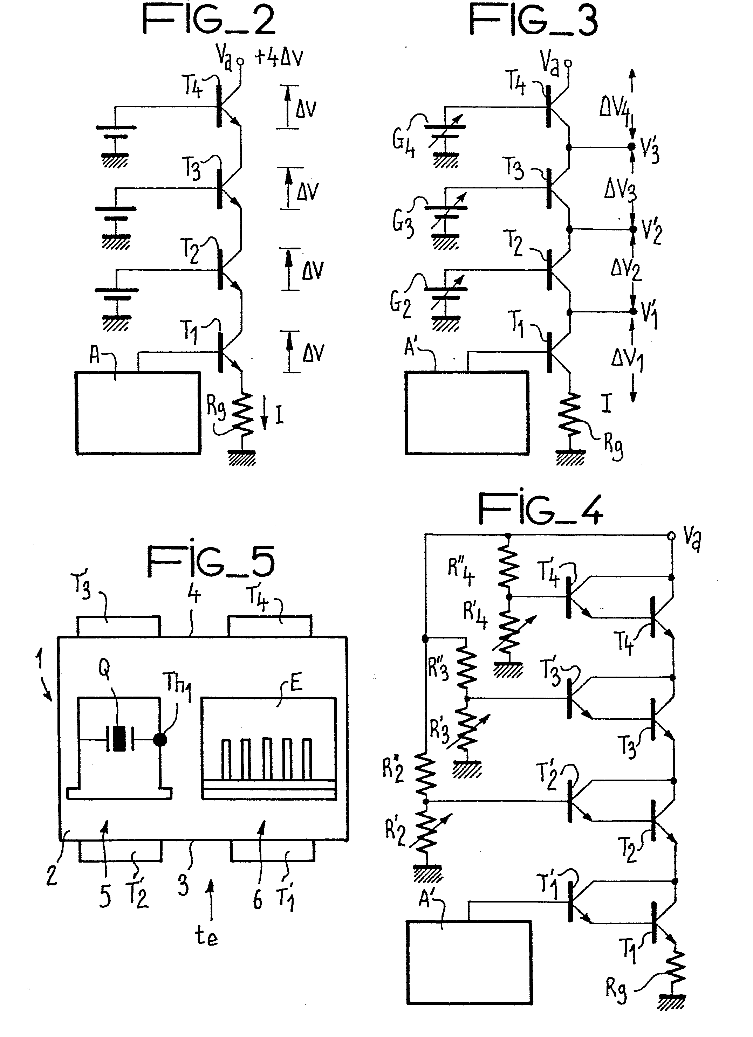

Selon la figure 3, au contraire, chacun des transistors $T_2$ à $T_4$ présente, selon l'invention, une tension de base variable. Pour ce faire, la base de chacun des transistors est alimentée par des générateurs de tension respectivement $G_2$ pour le transistor $T_2$, $G_3$ pour le transistor $T_3$ et $G_4$ pour le transistor $T_4$. Les générateurs $G_2$, $G_3$, $G_4$ permettent de faire varier les tensions de collecteur respectivement $V'_1$, $V'_2$ et $V'_3$ des transistors $T_1$, $T_2$, et $T_3$, permettant ainsi de modifier les différences de tension respectivement $V_1$, $V_2$, $V_3$ et $V_4$ entre l'émetteur et le collecteur respectivement des transistors $T_1$, $T_2$, $T_3$ et $T_4$. Il en résulte que ces trois réglages permettent de modifier les puissances relatives dissipées par les différents transistors de la chaîne.

Selon le mode de réalisation de la figure 4, à chacun des transistors $T_2$, $T_3$, $T_4$ et eventuellement $T_1$ est associé respectivement un transistor $T'_2$, $T'_3$ et $T'_4$ et éventuellement $T'_1$ avec lequel il forme un montage Darlington. Ceci permet d'obtenir une impédance d'entrée plus élevée et par conséquent d'alimenter les bases de chacun des transistors montés en Darlington à partir de la tension $V_a$ et du pont diviseur résistif avec une consommation électrique négligeable. Ainsi, les transistors $T'_2$, $T'_3$ et $T'_4$ reçoivent sur leur base la tension $V_a$ à partir des ponts diviseurs résistifs $R'_2$, $R''_2$, $R'_3$, $R''_3$, $R'_4$, $R''_4$. Un des élements au moins des ponts diviseurs résistifs est variable, par exemple respectivement la résistance $R'_2$, $R'_3$ et $R'_4$ connectée entre la base de chacun des transistors $T'_2$, $T'_3$, $T'_4$ et la masse.

Selon la figure 5, une enceinte thermostatée 1 présente dans une première région 5 un quartz Q disposé dans un boîtier qui est avantageusement en liaison thermique avec une thermistance $Th_1$, de telle sorte que la régulation thermique s'opère sur la variable la plus significative, à savoir la température du boîtier dans lequel est disposé le quartz Q. L'enceinte 1 présente, dans une seconde région 6, une électronique E associée au quartz Q, l'ensemble constituant un oscillateur. Les transistors de chauffage sont répartis sur deux parois opposées inférieure 3 et supérieure 4 d'une enceinte thermiquement conductrice 2.

Au niveau de la région 5, le transistor $T_2$ est placé en contact thermique avec la paroi inférieure 3, en vis-à-vis du transistor $T_3$ placé en contact thermique avec la paroi supérieure 4. Les transistors $T_2$ et $T_3$ sont de cette façon affectés au chauffage de la région 5 contenant le quartz Q.

De la même façon, au niveau de la région 6 le transistor $T_1$ est placé en contact thermique avec la paroi 3 en vis-à-vis du transistor $T_4$ en contact thermique avec la paroi 4, ces deux transistors étant affectés au chauffage de la région 6 contenant l'électronique associée au quartz Q.

Ainsi qu'il a été dit ci-dessus, il est relativement facile d'obtenir un bon couplage thermique entre le boîtier de l'élément piézo-électrique, notamment un quartz Q et le boîtier 2, alors que le couplage thermique de l'électronique E est plus lâche. Il en résulte qu'il faut chauffer un peu plus l'enceinte au niveau de la région 6 qu'au niveau de la région 5 afin d'éviter des inhomogénéïtés de température préjudiciables.

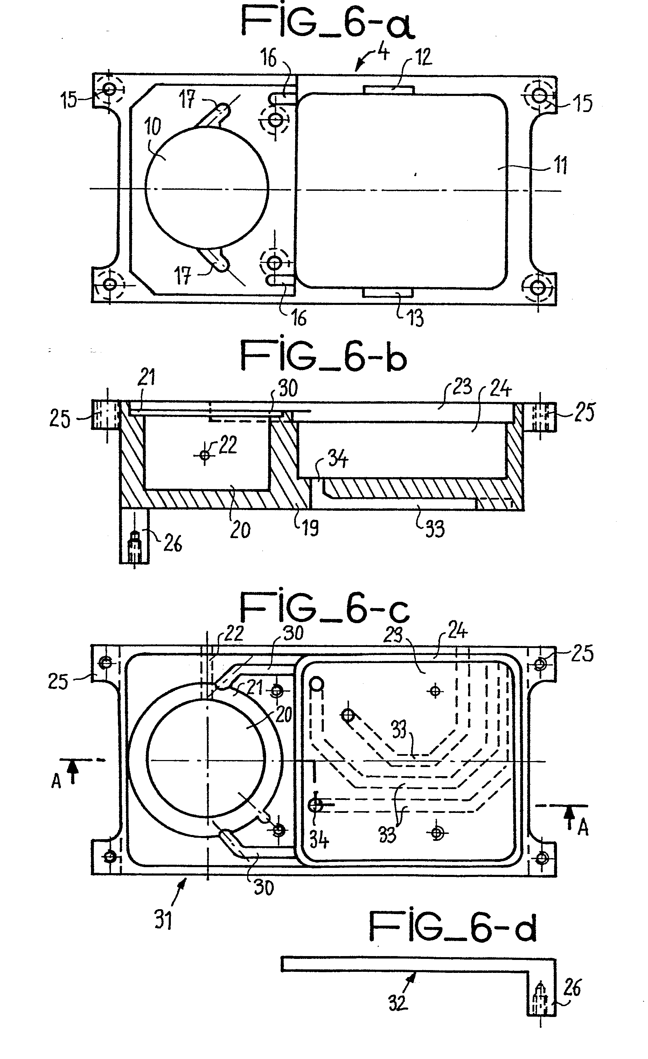

Selon un mode de réalisation, l'enceinte thermostatée comporte un capot supérieur 4 (figure 6a), un corps de boîtier 19 (en coupe verticale à la figure 6b et en vue de dessus à la figure 6c) et un capot inférieur 32 (figure 6d).

Le corps du boîtier 19, en matériau bon conducteur de la chaleur présente un alésage 20 formant une cavité destinée à recevoir le boîtier contenant le quartz maintenu sous vide. L'alésage 20 présente à cet effet, au jeu près, le même diamètre et la même hauteur que le boîtier du quartz, de telle sorte que celui-ci, maintenu par sa collerette qui est disposée dans un embrèvement 21, soit en contact thermique étroit avec le corps du boîtier 19. Ce contact thermique peut être encore amélioré par l'utilisation d'une graisse appropriée. Un alésage 22 de faible diamètre, ménagé depuis l'extérieur du corps du boîtier 19 et débouchant dans l'alésage 20, sert à loger une thermistance en contact thermique avec le boîtier de l'élément piézo-électrique, notamment un quartz Q.

Les fils de sortie de l'élément piézo-électrique sont guidés par des saignées 30 ménagées à la face supérieur du corps de boîtier 19, lesquelles débouchent dans une deuxième cavité 24 destinée à recevoir le circuit électronique comprimé ou hybride de l'oscillateur. Le circuit, retourné de telle sorte que ses composants soient situés dans la cavité 24 est posé par ses bords dans un embrèvement 23 de la cavité 24 et ses fils d'entrée, de sortie et d'alimentation passent par des alésages 34 et sont guidés à la face inférieure du corps de boîtier 19 dans des rainures 33, dans lesquelles il sont maintenus par un couvercle inférieur 32 à fond plat, réalisé en matériau bon conducteur de la chaleur. Cette disposition permet de maintenir les connexions électriques du circuit à la température régulée du corps du boîtier. La même fonction est remplie, en ce qui concerne les fils d'entrée et de sortie du quartz, par les saignées 30 mentionnées ci-dessus.

Le boîtier contenant le quartz et le circuit élecronique sont maintenus en position par le capot supérieur 4 réalisé en matériau bon conducteur de la chaleur. Il comporte en vue de sa fixation des patte 15 coopérant avec des pattes taraudées 15 du corps 19. Il comporte également un embrèvement 10 de profondeur suffisante pour permettre de recourber les fils de sortie du quartz en logeant une partie de leur courbures dans des portions de saignées 17 qui se superposent aux parties correspondantes des saignées 30. Pour faciliter la courbure des fils du côté de la cavité 24, des portions de saignées 16 sont également ménagées dans le capot 4 au dessus de la partie correspondante des saignées 30. L'embrèvement 10 à un diamètre à peu près égal à celui de l'alésage 20 de telle sorte qu'il permette le blocage en position de la collerette du boîtier du quartz. Le capot 4 comporte également deux ergots 12 et 13 ménagés sur des côtés opposés d'un embrèvement 11 et destinés à plaquer les bords du circuit dans l'embrèvement 23.

11

On va maintenant décrire comment, dans le cas de la figure 5 et des figures associées 6a et 6d, on règle les puissances de chauffe des transistors respectifs de manière à réaliser cette compensation. On notera tout d'abord que les inhomogénéïtés thermiques se produisent dans le sens longitudinal du boîtier entre la région 5 et la région 6, mais que celui-ci est thermiquement symétrique dans le sens latéral. On peut donc faire dissiper la même puissance aux transistors $T_2$ et $T_3$ d'une part, et la même puissance au transistor $T_1$ et $T_4$ d'autre part.

Sur le schéma à quatre transistors des figures 3 et 4, le réglage est obtenu en maintenant $V'_2 = V_a/2$ et en modifiant $V'_a$ et $V'_3$ de telle sorte que $\Delta V_2 = \Delta V_3$, d'où il résulte que $\Delta V_1 = \Delta V_4$. Le réglage de la chaîne de transistors se résume alors au réglage d'un seul paramètre, à savoir le décalage symétrique des tensions $V'_1$ et $V'_3$ par rapport à la tension $V'_2$. Dans ce type de réglage, il n'est pas besoin que la tension de base de $T_3$ soit réglable, car on ne modifie pas la valeur de $V'_2$.

On va maintenant montrer comment on effectue le réglage dans le cas d'une enceinte telle que représentée à la figure 5. Dans un premier temps, on soumet l'enceinte thermostatée 1 à une température voisine de la température maximale de la gamme de fonctionnement prévue, par exemple en disposant l'enceinte 1 dans une étuve. On mesure alors la fréquence $f_0$ de l'oscillateur. Etant donné que la température de consigne de l'enceinte thermostatée est très proche de la température extérieure, les inhomogénéïtés de températures à l'intérieure de l'enceinte sont très faibles et la fréquence $f_0$ ainsi mesurée sert de référence pour tester la qualité thermique de l'enceinte 1.

Dans une deuxième étape, on soumet l'enceinte thermostatée à une température extérieure voisine de la température minimale de la gamme de température prévue. On mesure alors la fréquence de l'oscillateur qui a pour valeur $f_0 + f_0$, $\Delta f_0$ pouvant être positif ou négatif. L'existence de $\Delta f_0$ est représentative de l'inhomogénéïté de température de l'enceinte, étant donné que la température de

12

l'électronique n'est plus égal à celle du quartz qui est prise comme référence du fait de l'emplacement de la thermistance. Une légère variation de température de l'électronique induit en effet une telle légère variation $\Delta f_0$ de la fréquence $f_0$ de l'oscillateur.Les inhomogénéîtés de température dans l'enceinte sont dues au fait que les apports thermiques à l'enceinte ne sont pas répartis rationnellement. Le réglage consiste à annuler l'écart $\Delta f_0$ en modifiant la répartition des puissances dissipées par des éléments de chauffage. Comme indiqué plus haut, on fait $\Delta V_2 = \Delta V_3$ et on fait varier cette valeur jusqu'à ce que la compensation soit obtenue. La compensation ayant été réalisée aux extrémités de la gamme de température de fonctionnement de l'enceinte, elle sera valable pour toute cette gamme.

A titre d'exemple, pour un mode particulier de réalisation d'une enceinte 1, et pour une tension d'alimentation $V_a = 24$ volts et donc $V'_2 = 12$ volts, on a trouvé les valeurs suivantes :

$$V'_1 = 10,5 \text{ volts et, } V'_3 = 13,5 \text{ volts}$$

La dérive relative de fréquence de l'oscillateur dans toutes la gamme de fonctionnement à savoir de moins 40° à plus 70° a été limitée à $210^{-10}$, ce qui correspond a une amélioration au moins égale à un ordre de grandeur.

13

# REVENDICATIONS

1. Procédé permettant le réglage du chauffage d'une enceinte thermostatée d'un oscillateur, dont le chauffage est assuré par une pluralité d'éléments de chauffage asservis à faire correspondre la température mesurée (tmes) de l'enceinte à une température de référence (tréf) caractérisé en ce qu'il comporte les étapes suivantes :

a - soumettre l'enceinte thermostatée (1) à une température extérieure (te) voisine de la température maximale (tmax) de la gamme de température prévue pour l'enceinte (1) et mesurer la fréquence $f_0$ de l'oscillateur.

b - soumettre l'enceinte thermostatée (1) à une température extérieure (te) voisine de la température minimale (tmin) de la gamme de température prévue pour l'enceinte (1) et annuler l'écart $(\Delta f_0)$ de fréquence de l'oscillateur par rapport à la fréquence $(f_0)$ mesurée précédemment, en modifiant la répartition de puissances dissipées par les différents éléments de chauffage $(T_1...T_n)$ d'où il résulte que l'on compense au moins partiellement les défauts d'homogénéïté de température à l'intérieure de l'enceinte (1) sur toute la gamme (tmin, tmax) de température de fonctionnement de l'oscillateur.

2. Procédé selon la revendication 1, caractérisé en ce que lors de l'étape a, on procède à l'ajustage de la température de référence (tréf).

3. Procédé selon une des revendications 1 ou 2, caractérisé en ce que le circuit de chauffage comporte une chaîne de circuits semiconducteurs stabilisateurs de tension reliés en série $(T_1...T_n)$, et soumis à une fraction réglable d'une tension d'alimentation $(V_a)$ de manière à permettre ladite modification de la répartition des puissances dissipées, les circuits semiconducteurs étant traversés par un courant de chauffage (I) commandé par l'intermédiaire d'un

14

circuit de commande qui est situé à une extrémité de la chaîne et est soumis à un signal de contrôle ($V_C$) représentatif de l'écart entre la température mesurée (tmes) de l'enceinte et la température de référence (tréf).

4. Procédé selon la revendication 3, caractérisé en ce que le circuit de commande constitue un circuit semiconducteur de la chaîne.

5. Procédé selon une des revendications 1 à 4, caractérisé en ce que le circuit de chauffage comportant quatre éléments à savoir successivement un premier ($T_1$), un deuxième ($T_2$), un troisième ($T_3$) et un quatrième ($T_4$), ladite modification de la répartition des puissances dissipées s'effectue en décalant de manière symétrique et en sens contraire lesdites fractions des tension d'alimentation des deuxième ($T_2$) et quatrième ($T_4$) circuits semiconducteurs stabilisateurs de tension.

6. Dispositif adapté à la mise en oeuvre du procédé selon une des revendications précédentes, caractérisé en ce qu'il comporte d'une part un circuit de contrôle (A) de température d'une enceinte (1) d'un oscillateur à quartz comportant un capteur de température ($Th_1$) et d'autre part un circuit de chauffage de l'enceinte (1) alimenté par une source de tension ($V_A$) et régulé par le circuit de contrôle de température, celui-ci délivrant un signal de contrôle représentatif de l'écart entre la température mesurée (tmes) de l'enceinte et une température de référence (tréf), le circuit de chauffage étant constitué par une chaîne de circuits semiconducteurs stabilisateurs de tension ($T_1$...,$T_n$) reliés en série, au moins un desdits circuits stabilisateurs de tension ($T_2$, $T_4$) présentant un moyen pour modifier sa tension stabilisée, chacun des circuits semiconducteurs étant traversé par un courant de chauffage (I) régulé par l'intermédiaire d'un circuit de commande qui est situé à une extrémité de ladite chaîne et est soumis audit signal de contrôle

$(V_C)$, en ce que les circuits stabilisateurs de tension assurant le chauffage de ladite enceinte (1) sont répartis dans une pluralité de régions de l'enceinte (I) et en ce que la modification d'au moins une dite tension stabilisée est réalisée de manière à compenser au moins partiellement les défauts d'homogénéité de température à l'intérieur de l'enceinte.

7. Dispositif selon la revendication 6, caractérisé en ce que le circuit de commande constitue un circuit semiconducteur de la chaîne.

8. Dispositif selon la revendication 5, caractérisé en ce que le capteur de température $(Th_1)$ est disposé au voisinage du boîtier d'un élément piézo-électrique (Q) de l'oscillateur et en contact thermique avec celui-ci.

9. Dispositif selon une des revendications 6 à 8, caractérisé en ce que les circuits stabilisateurs de tension $(T_1 - T_n)$ sont répartis sur le pourtour de l'enceinte thermostatée (1).

10. Dispositif selon la revendication 9, caractérisé en ce que les circuits stabilisateurs de tension sont en contact thermique avec un boîtier (2) thermiquement conducteur constituant l'enceinte thermostatée (1) et dans lequel sont disposés le boîtier de l'élément piézo-électrique (Q) de l'oscillateur et son électronique (E) associée.

11. Dispositif selon une des revendication 9 ou 10, caractérisé en ce que l'enceinte thermostatée (1) comporte une première région (5) où est disposé l'élément piézo-électrique(Q) et une deuxième région (6) où est disposée son électronique associée (E), et en ce que les circuits stabilisateurs de tension $(T_1...T_n)$ sont disposés selon un premier groupe $(T_2, T_3)$ en vis-à-vis de la première région (5) et selon un deuxième groupe $(T_1, T_4)$ en vis-à-vis de la deuxième région (6).

16

12. Dispositif selon une des revendications 6 à 11, caractérisé en ce que les circuits stabilisateurs de tension $(T_1...T_n)$ sont constitués par une chaîne de transistors recevant chacun sur sa base une tension donnée, l'émetteur et le collecteur des transistors adjacents étant reliés entre eux, la modification d'au moins une tension stabilisée consistant en le réglage de la tension de base d'au moins un des transistors $(T_1...T_n)$ de la chaîne.

13. Dispositif selon la revendication 11, caractérisé en ce que les circuits stabilisateurs de tension sont constitués par une chaîne de quatre transistors, à savoir successivement un premier $(T_1)$, un deuxième $(T_2)$, un troisième $(T_3)$ et un quatrième transistors $(T_4)$, recevant chacun sur sa base une tension donnée, l'émetteur et le collecteur des transistors adjacents étant reliés entre eux, en ce que les circuits stabilisateurs d'un desdits groupes sont constitués par les deux transistors extrêmes de la chaîne $(T_1, T_4)$ et ceux de l'autre groupe par les deux transistors centraux $(T_2, T_3)$ de la chaîne, et en ce que les tensions de base du deuxième $(T_2)$ et du quatrième $(T_4)$ transistor de la chaîne sont réglables.

14. Dispositif selon la revendication 13, caractérisé en ce que ledit premier groupe est constitué par les deux transistors centraux de la chaîne à savoir le deuxième $(T_2)$ et le troisième $(T_3)$ et ledit second groupe par les deux transistors extrêmes de la chaîne, à savoir le premier $(T_1)$ et le quatrième $(T_4)$.

15. Dispositif selon une des revendication 12 à 14, caractérisé en ce qu'au moins un transistor $(T_1...T_n)$ dont la tension de base est réglable est monté en Darlington, la tension de base d'entrée d'un Darlington étant alors donée par un pont diviseur $(R'_2, R''_2, R'_3, R''_3, R'_4, R''_4)$ alimenté à la tension constante.

# FIG_1

FIG_2

FIG_3

FIG_5

FIG_4

2/3

0142410

FIG_6-a

16 4 12
15 17 15
10 11
17
16 13

FIG_6-b

21 30 23 24
25 25
22 34
26 20 19 33

FIG_6-c

22 30 23 24
25 25
21
20
A 33
A
34 33
30
31

FIG_6-d

32 26

**0142410**

Office européen
des brevets

**RAPPORT DE RECHERCHE EUROPEENNE**

Numéro de la demande

EP 84 40 2042

## DOCUMENTS CONSIDERES COMME PERTINENTS .

| Categorie | Citation du document avec indication. en cas de besoin. des parties pertinentes | Revendication concernée | CLASSEMENT DE L.. DEMANDE (Int. Cl 4) |
|---|---|---|---|
| A,D | EP-A-0 004 233 (COMPAGNIE D'ELECTRONIQUE ET DE PIEZOELECTRICITE-C.E.P.E.) * page 5, lignes 19-25; figures 1,4 *<br><br>----- | 1,6-9 | G 05 D 23/24<br>H 03 L 1/04 |

| | | | DOMAINES TECHNIQUES RECHERCHES (Int. Cl.4) |
|---|---|---|---|
| | | | G 05 D<br>H 03 L<br>H 03 H |

Le présent rapport de recherche a été établi pour toutes les revendications

| Lieu de la recherche LA HAYE | Date d'achèvement de la recherche 16-01-1985 | Examinateur HELOT H.V. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82